Europäisches Patentamt

European Patent Office

Office européen des brevets

(11) Publication number: **0 184 171**
A2

## (12) EUROPEAN PATENT APPLICATION

(21) Application number: 85115246.2

(22) Date of filing: 30.11.85

(51) Int. Cl.⁴: **H 01 L 23/52**

(30) Priority: 06.12.84 US 679132

(43) Date of publication of application:
11.06.86 Bulletin 86/24

(84) Designated Contracting States:
DE FR GB NL

(71) Applicant: Solid State Devices, Inc.
14830 Valley View Avenue
La Mirada California 90673(US)

(72) Inventor: Bartur, Meir
1170 East Del Mar Apt. 5
Pasadena, Calif. 91106(US)

(74) Representative: von Kreisler, Alek, Dipl.-Chem. et al,
Deichmannhaus am Hauptbahnhof
D-5000 Köln 1(DE)

(54) Device having improved contact metallization.

(57) The present invention solves the problem of contact surface roughening by providing contact metallization having physical barriers within the metallization which prevent significant movement of metal particles during temperature cycling of the metallization. In general, the contact metallization includes a conductive constituent and a barrier constituent. Preferably, layers of the conductive constituent are interspersed with layers of the barrier constituent. The resulting contact metallization is free from significant contact surface roughening thereby minimizing the problem of shorts in the device.

EP 0 184 171 A2

DEVICE HAVING IMPROVED CONTACT METALLIZATION

BACKGROUND OF THE INVENTION

     1.  Field of the Invention

     This invention relates to electronic devices of the type having a conductive element joined by contact metallization to a conductive substrate. In particular, the present invention relates to electronic devices having improved thin film contact metallization wherein the problem of surface contact roughening is significantly eliminated.

     2.  Prior Art

     In many electronic devices, such as diodes, for example, an aluminum wire is ultrasonically bonded to a single layer of aluminum contact metallization, which is deposited over a conductive substrate. When such devices are subjected to alternating current (e.g., 60 Hz) burn-in, the aluminum contact metallization often becomes discolored. By examining the discoloration by scanning electron microscopy, it was determined that the discoloration of the aluminum metallization was due to a change in the surface finish of the contact metallization. Namely, the surface finish had a roughened appearance which altered the reflectivity of the metallization resulting in the discolored optical appearance. X-ray dispersive spectroscopy analysis of the smooth (unaltered) surface with an adjacent roughened area found both to be essentially the same, namely aluminum.

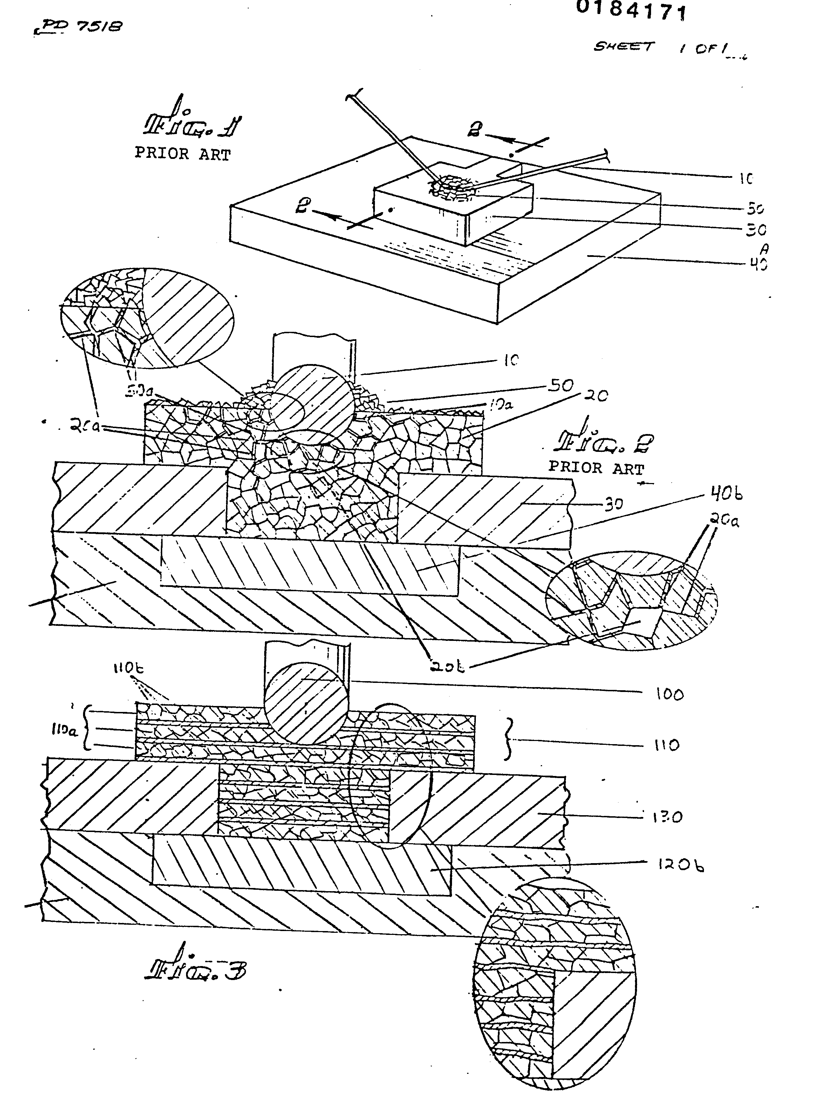

The contact surface roughening is more clearly illustrated in Figures 1 and 2, wherein aluminum wire 10 is shown bonded to aluminum contact metallization 20 which is deposited over semiconductor substrate 40a having doped region 40b (a silicon dioxide insulator 30 is also illustrated). In Figure 1, the roughening, generally at 50, is shown covering a portion of the aluminum wire and a portion of the aluminum contact metallization. In Figure 2, some of the roughening 50 can also be seen wedged in junction 10a between the wire 10 and the contact metallization 20 thereby creating a space between the wire and the metallization, leading to deterioration of the connection and ultimately to shorts.

It is believed that contact surface roughening is due to a phenomenon described as grain boundary reconstruction. See A.C Macpherson, et al., "Effects of Fast Temperature Cycling on Aluminum and Gold Metal Systems", Reliability Physics Symposium, pp. 113-115 (1974). With reference to Figure 2, the basic mechanism of grain boundary reconstruction is described as follows. As the device shown is cyclically heated and cooled, either by ambient temperature cycling or by self-induced temperature cycling by AC power pulsing, the aluminum contact metallization 20 expands and contracts. The temperature swing during each cycle can range from about $30^{\circ}C$ to over $100^{\circ}C$ on cells of commercial transistors at rated power output.

As stated above, during temperature cycling, the aluminum contact metallization expands and contracts. On large grain metals, such as aluminum, the expansion causes aluminum particles 50a to travel to and along aluminum grain boundaries 20a, in general, moving in a direction away from the semiconductor substrate and towards the outer surface of the contact metallization 20. Eventually, after further cycling, the contact metallization may crack at the surface, permitting the extrusion of the traveling aluminum particles thereby forming the roughening shown generally at 50. (A moat or pocket 20b may also form in the contact metallization during temperature cycling.)

The description above is generally simplified but the end result, after many temperature cycles, is severe roughening of the contact metallization. The roughening increases the sheet resistivity of the contact metallization and decreases the ability of the contact metallization to evenly conduct current. Gradually, hot spots and localized high current density sites develop in the contact metallization and the device shorts out. Obviously, this is a rapidly accelerating mechanism because as roughening occurs current distribution changes, more localized heating occurs, and the surface contact roughening problem accelerates, eventually causing device failure.

It is known that silicon dioxide overcoat passivisation on commercially prepared aluminum metallization decreases the roughening of the passivated areas. It is also known that in thin film structures such as Schottky barrier contacts, a layer of aluminum having a high aluminum oxide content spaced between a layer of tantalum (or other transition metal) and a layer of pure aluminum functions as a diffusion barrier between the aluminum and the metal. See U.S. Patent No. 4,206,472 to Chu et al. However, there have apparently been no improvements made to contact metallization techniques which eliminate the problem of contact surface roughening.

## BRIEF DESCRIPTION OF THE DRAWINGS

Figure 1 is a perspective view of a prior art electronic device showing contact surface roughening.

Figure 2 is a schematic cross sectional view of the electronic device of Figure 1 taken along line 2-2 of Figure 1.

Figure 3 is one embodiment of the device having the improved contact metallization of the present invention.

0184171

## SUMMARY OF THE INVENTION

The present invention is directed to an electronic device having improved contact metallization. In particular, when the device of the present invention is subjected to temperature cycling such as that caused by the application of alternating current, contact surface roughening is significantly decreased and the integrity of the connection is maintained.

The present invention solves the problem of contact surface roughening by providing contact metallization having physical barriers within the metallization which prevent significant movement of metal particles during temperature cycling of the metallization without altering the conductivity of the metallization. In general, the contact metallization includes a conductive constituent and a barrier constituent, the conductive constituent being granular. The two constituents are associated together in the contact metallization such that metal particle transport along the grain boundaries of the granular conductive constituent is minimized. Preferably, the contact metallization comprises layers of the conductive constituent interspersed with layers of the barrier constituent. The layers of the barrier constituent act as physical barriers to prevent particles of the conductive constituent from transporting from one layer of the conductive constituent to another layer of the conductive constituent. The resulting contact metallization is free from significant contact surface roughening thereby minimizing the problem of shorts in the device.

DESCRIPTION OF THE PREFERRED EMBODIMENT

The following description is of the best presently contemplated mode of carrying out the invention. This description is made for the purpose of illustrating the general principles of the invention and is not to be taken in a limiting sense. The scope of the invention is best determined by the appended claims.

Referring to Figures 1 and 2, prior art electronic device (e.g., a diode) is shown with conductive element, e.g., aluminum wire 10, bonded to contact metallization 20 which in turn overlies semiconductor substrate 40a having doped region 40b. Silicon dioxide insulating layer 30 is provided between a portion of contact metallization 20 and the substrate 40a.

As discussed previously, and as shown in Figures 1 and 2, ambient temperature cycling or temperature cycling induced by applying alternating current to the aluminum wire 10 causes grain boundary reconstruction which in turn causes contact surface roughening shown generally at 50. Aluminum particles 50a, which move to and along the aluminum grain boundaries 20a, eventually are extruded through cracks formed in the surface of the contact metallization 20. Pockets or holes 20b may also be formed in the contact metallization during temperature cycling. The contact surface roughening eventually causes the device to short out, resulting in device failure.

The present invention eliminates the problem of contact surface roughening so that during temperature cycling, cracks, pockets and holes are not formed in the contact metallization, aluminum particles are not extruded, the contact metallization surface remains smooth, and the problem of device shorts due to contact surface roughening is eliminated. These advances result from the present invention without sacrificing contact conduction and device integrity.

With reference to Figure 3, one embodiment of the present invention is shown with conductive element, e.g., aluminum wire 100, bonded to contact metallization 110 which in turn overlies semiconductor substrate 120a having doped region 120b. Silicon dioxide insulation 130 is also shown and is spaced between a portion of the contact metallization 110 and the substrate 120a.

In the present invention, the contact metallization comprises a granular conductive constituent and a barrier constituent. The barrier constituent physically limits movement of metal particles along the grain boundaries of conductive constituent during temperature cycling without altering the overall contact conduction. In the preferred embodiment shown in Figure 3, the contact metallization comprises alternating layers of a conductive constituent (e.g., aluminum) and a barrier constituent (e.g., aluminum oxide). Thus as shown in Figure 3, layers 110a consist essentially of aluminum and layers 110b consist essentially of aluminum oxide. Preferably there are from about 7 to about 10 layers of aluminum and a like number of layers of aluminum oxide; although, the present invention contemplates the use of at least two aluminum and at least two aluminum oxide layers. Each aluminum layer has a thickness of from about 500 angstroms to about 2 microns, and preferably about 5,000 angstroms. Spaced between the aluminum layers are layers of aluminum oxide, about 15-30 angstroms thick. Of course, the thickness of the layers may vary so long as the barrier constituent is thick enough to limit conductive constituent particle transport during temperature cycling without materially affecting the overall contact conduction.

To produce an electronic device of the present invention having the layered contact metallization, the thin film contact metallization can be deposited by high vacuum evaporation or sputtering. In the preferred embodiment, a layer of aluminum is deposited over the semiconductor substrate and the deposited layer of aluminum is exposed to oxygen to form an aluminum oxide layer. To oxidize the aluminum to thereby form the aluminum oxide layer, oxygen is increased in the vacuum evaporation system by opening the pump in the vacuum evaporator or bleeding in water, air or oxygen. The system is then returned to high vacuum to deposit another layer of aluminum, which is subsequently exposed to oxygen to form another aluminum oxide layer. This process is repeated until there are present in the contact metallization the desired number of layers.

While the preferred embodiment utilizes aluminum and aluminum oxide layered contact metallization, other metals are within the scope of the present invention. Aluminum is generally preferred due to its inexpensiveness and its inherent ability to easily oxidize. Further, although aluminum oxide is preferred, any other material which does not materially affect the overall contact conduction and which also limits aluminum particle transport during temperature cycling can be utilized. The present invention also has application to any electronic device which is subject to temperature cycling, for example, aluminum lines. Further, and in another embodiment of the present invention, the contact metallization or aluminum lines may be formed from tiny grains of aluminum coated with aluminum oxide.

0184171

I CLAIM:

1. An electronic device having contact metallization, the contact metallization comprising:

a granular conductive constituent; and

barrier means for physically blocking transportation of particles of the conductive constituent along the grain boundaries of the conductive constituent during temperature cycling of the device thereby to prevent significant surface roughening of the contact metallization.

2. An electronic device according to claim 1 wherein the barrier means is an oxide of the conductive constituent.

3. An electronic device according to claim 1 wherein the contact metallization comprises alternating layers of the barrier means and the conductive constituent.

4. An electronic device according to claim 1 wherein the conductive constituent is aluminum and the barrier means is aluminum oxide.

5. An electronic device according to claim 4 wherein the aluminum layers are about 500 angstroms to about 2 microns thick and the aluminum oxide layers are about 15 angstroms to about 30 angstroms thick.

6. An electronic device according to claim 3 wherein there are at least two conductive constituent layers and at least two barrier means layers in the contact metallization.

7. An electronic device of the type having 0184171 conductor connected by contact metallization to a substrate, the electronic device comprising:

a wire;

a semiconductor substrate; and

a thin film of material spaced between the wire and the semiconductor substrate, the thin film material comprising at least two layers of aluminum and at least two layers of aluminum oxide.

8. An electronic device according to claim 7 wherein the layers of aluminum are from about 500 angstroms to about 2 microns thick and wherein the layers of aluminum oxide are from about 15 to about 30 angstroms thick.

9. A method for forming contact metallization on an electronic device of the type having a conductor connected by contact metallization to a substrate, the method comprising the steps of:

depositing a first layer of aluminum on the substrate;

exposing the first layer of aluminum to an oxygen source to thereby form a first layer of essentially aluminum oxide;

depositing a second layer of aluminum on the first layer of aluminum oxide; and

exposing the second layer of aluminum to the oxygen source to thereby form a second layer of essentially aluminum oxide.

10. A method for forming contact metallization according to claim 9 where the aluminum is deposited by vacuum evaporation.

11. A method for forming contact metallization according to claim 9 wherein the deposition and exposure steps are repeated until there are formed from three to ten layers each of aluminum and essentially aluminum oxide.

PD 7518

FIG. 1
PRIOR ART

FIG. 2
PRIOR ART

FIG. 3